# EUROPEAN PATENT SPECIFICATION

(11) **EP 2 802 004 B1**
(45) Date of publication and mention of the grant of the patent: **04.11.2020**
(21) Application number: 13167088.7
(22) Date of filing: 08.05.2013
(51) Int. Cl.: H01L 21/311, H01L 21/3213, H01L 21/768

(54) **Method of structuring a device layer of a recessed semiconductor device and recessed semiconductor device comprising a structured device layer**
Verfahren zur Strukturierung einer Vorrichtung aus einem vertieften Halbleitervorrichtung und vertieften Halbleitervorrichtung umfassend eine strukturierte Vorrichtungsschicht
Procédé de structuration d'une couche de dispositif d'un dispositif à semi-conducteur en retrait et dispositif à semi-conducteur en retrait comprenant une couche de dispositif structurée

(43) Date of publication of application: 12.11.2014
(73) Proprietor: ams AG, 8141 Premstätten (AT)
(72) Inventor: Löffler, Bernhard, 8200 Gleisdorf (AT); Schrems, Martin, 8063 Eggersdorf (AT)
(74) Representative: Epping - Hermann - Fischer

(56) References cited:
- DE-A1-102009 045 385
- US-A1- 2003 129 840
- US-A1- 2006 009 038
- US-A1- 2010 038 800
- US-A1- 2012 068 356

## Description

WO 2012/052039 discloses an apparatus for coating a surface of a wafer. The apparatus can be used in a nanospray process for the application of an organic photoresist on a surface including a sidewall and a bottom of a through substrate via.

US 2012/0190204 A1 discloses a non-conformal hardmask deposition for through silicon etch in order to provide a method to form deep features in a stacked semiconductor structure. The non-conformal hardmask is deposited onto a patterned topography to protect all but recessed areas.

US 2005/048771 A1 discloses a hardmask employing multiple layers of silicon oxynitride. A bi-layer BARC/hardmask structure includes a layer of amorphous carbon and two or more distinct layers of a PECVD material such as SiON formed on the amorphous carbon layer. By independently forming several layers of PECVD material, at least some pinholes that are present in the lowermost layer are closed by upper layers and therefore do not extend through all of the PECVD layers. As a result, the upper surface of the uppermost layer has a lower pinhole density than the lower layer. This reduces photoresist poisoning by dopant in the amorphous carbon layer, and etching of the amorphous carbon layer by photoresist stripping chemistry. This method is intended for planar structures and does not provide a removable mask layer covering the surface of an open through substrate via.

US 2010/0038800 A1 discloses through-silicon via structures. An insulating layer is formed on an upper surface of a substrate, and a layer sequence, which includes an insulator layer, a diffusion barrier layer and a conductive protective layer, is formed on the insulating layer and inside a recess provided for the via.

US 2012/0068356 A1 discloses a component having a via in a semiconductor substrate. A trench structure surrounds a via portion of the substrate. A masking layer comprising a perforation region, which is formed above the trench structure, and a passivation layer are applied above the via.

DE 102009045385 A1 discloses a method for sealing a trench of a micromechanical device comprising a dielectric layer with a grating, a further dielectric layer closing the grating, and a conductive layer of metal or a metal alloy.

US 2006/0009038 A1 discloses a method of creating a planarized surface above a cavity in a semiconductor substrate to facilitate subsequent lithography steps.

EP 0 665 579 A1 discloses a method of fabricating an integrated circuit device having a gate stack of reduced height, which uses a patterned oxide hardmask to pattern an underlying metal layer. The oxide mask is removed and the patterned metal is subsequently used as a mask to etch a polysilicon layer. This method is not suitable for structuring layers on a surface that is recessed by a through substrate via.

US 2003/129840 A1 discloses a method of etching a high aspect ratio, deep trench opening in a silicon substrate. A photoresist mask layer is employed to etch a trench into a hardmask layer. The hardmask layer is employed as a mask while etching a trench into underlying layers.

It is an object of the present invention to disclose a method of structuring a device layer of a recessed semiconductor device, in particular a semiconductor device comprising a through-substrate via. It is a further object to disclose a recessed semiconductor device comprising a structured device layer that can be produced by the method.

These objects are achieved with the method according to claim 1 and with the semiconductor device according to claim 10. Embodiments and variants derive from the dependent claims.

The method of structuring a device layer of a recessed semiconductor device comprises the steps of providing a semiconductor substrate with a device layer having a surface, forming a recess extending from the surface into the substrate, and structuring the device layer. A dry film is applied on the surface of the device layer after forming the recess and before structuring the device layer, so that the dry film covers the recess. A resist layer is applied on or above the dry film and is patterned into a resist mask. A dry film pattern is formed from the dry film according to the pattern of the resist mask. The device layer is structured using the dry film pattern as an etch mask.

The dry film may be formed from an organic material, in particular from polyimide.

In a variant of the method, the dry film is applied with a thickness in the range from 5 µm to 50 µm.

In a further variant of the method, the resist layer is formed by spin-coating.

The recess forms a via in the substrate, and the dry film pattern is left covering an inner volume of the recess after structuring the device layer.

In a further variant of the method, a hardmask layer is applied on the dry film, the resist layer is applied on the hardmask layer, the resist mask is used to structure the hardmask layer into a hardmask, and the hardmask is used to structure the dry film into the dry film pattern.

In a further variant of the method, the resist mask is removed before the dry film is structured into the dry film pattern using the hardmask.

In a further variant of the method, the hardmask is removed before the device layer is structured using the dry film pattern.

The semiconductor device comprises a substrate with a recess forming a via opening and a structured device layer arranged between the substrate and a dry film pattern. The dry film pattern covers the recess and comprises outlines that correspond to outlines of the structured device layer.

In an embodiment of the semiconductor device, the dry film pattern comprises an organic material, in particular polyimide.

In a further embodiment the dry film pattern is arranged between the structured device layer and a hardmask comprising a material selected from the group consisting of silicon, SiO₂, Si₃N₄ and aluminum.

The following is a detailed description of examples of the method and the semiconductor device.
- Figure 1: is a cross section of an intermediate product of an example of the method.
- Figure 2: is a cross section according to Figure 1 after the application of a resist mask.
- Figure 3: is a cross section according to Figure 2 after the formation of a dry film pattern.
- Figure 4: is a cross section according to Figure 3 after the structuring of the device layer.
- Figure 5: is a cross section according to Figure 1 for a further example of the method.
- Figure 6: is a cross section according to Figure 5 after the application of a resist mask.
- Figure 7: is a cross section according to Figure 6 after the patterning of a hardmask.
- Figure 8: is a cross section according to Figure 7 after the formation of a dry film pattern.
- Figure 9: is a cross section according to Figure 8 after the structuring of the device layer.
- Figure 10: is a cross section according to Figure 9 after the removal of the patterned masking layers.

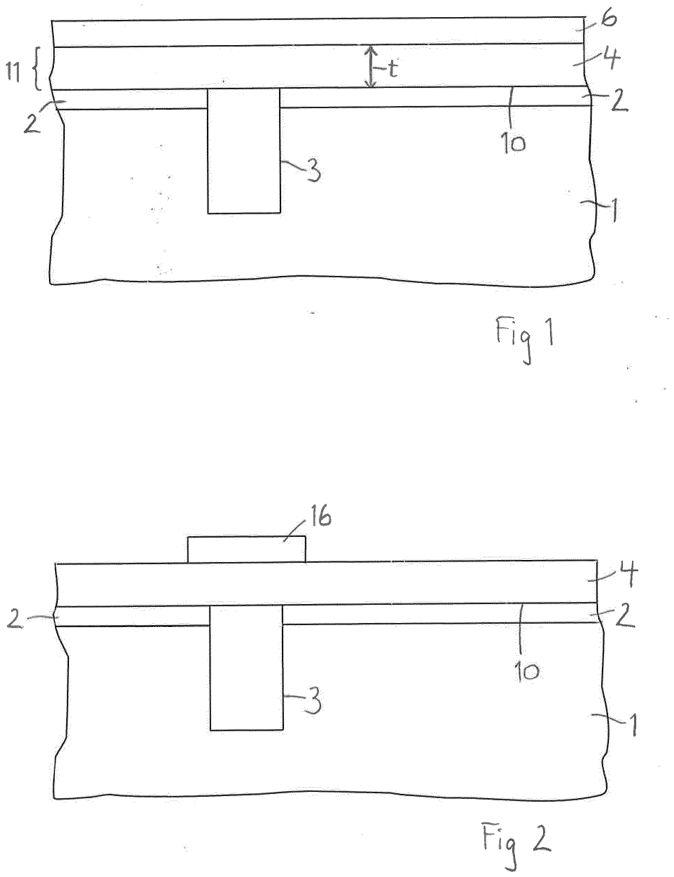

Figure 1 is a cross section of a substrate 1 of semiconductor material carrying a device layer 2, which has an upper surface 10 and may be formed by a single layer or by a multiple layer. The device layer 2 can comprise any material used in semiconductor technology, like W, Al, Cu, Si, SiO₂ or Si₃N₄, for instance, which is to be structured in order to provide a special function of the semiconductor device. A recess 3 is formed extending from the surface 10 into the substrate 1. The recess 3 may especially be provided for a through substrate via, which provides an electric interconnect through the substrate 1. The device layer 2 is structured by means of a special mask technique.

In the example of a method according to Figures 1 to 4, a dry film 4, which is provided as a mask layer 11, is applied on the surface 10 of the device layer 2, so that the dry film 4 covers the recess 3 and renders a planar upper surface of the device. An organic material may be especially suitable for the dry film 4, which is preferably applied with a thickness t in the range from 5 µm to 50 µm and is formed by dry-film lamination, with deliberately low step coverage. If the dry film 4 is formed from polyimide, it is stable in temperatures of up to 350°C.

A resist layer 6, which may comprise an organic resist, for instance, is applied on the dry film 4. The resist layer 6 is preferably very thin, so that its thickness is much less than 1 µm, thus allowing for small structures to be resolved. A photolithography is performed, in which the resist layer 6 is subjected to a patterned light exposure and subsequent development, so that it can be partially removed according to the desired pattern by means of a solvent.

Figure 2 is a cross section according to Figure 1 after the patterning of the resist layer 6 into a resist mask 16.

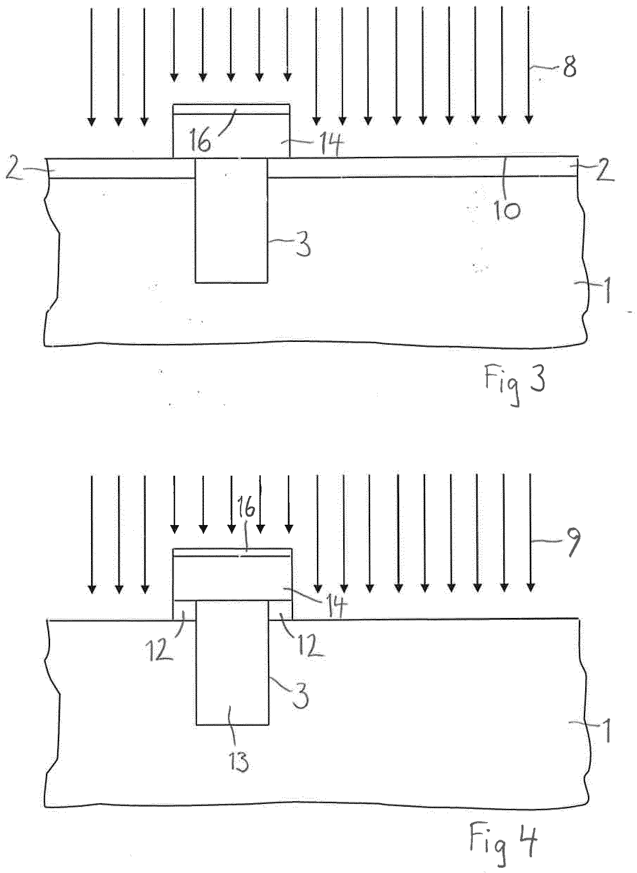

Figure 3 is a cross section according to Figure 2 after structuring the dry film 4 into a dry film pattern 14 using the resist mask 16 as an etch mask. The dry film etching 8 is indicated in Figure 3 by a plurality of arrows pointing downwards. The resist mask 16 is partially consumed during this etching step, which is indicated in Figure 3 by the layer representing the resist mask 16 being thinner than the corresponding layer in Figure 2. The etching stops on the surface 10 of the device layer 2. As the dry film 4 had been applied sufficiently thick, the dry film pattern 14 still covers the recess 3.

Figure 4 is a cross section according to Figure 3 after the structuring of the device layer 2. This is performed using the dry film pattern 14 as an etch mask. The device layer etching 9 is indicated in Figure 4 by a plurality of arrows pointing downwards. Residual portions of the device layer 2 remain under the dry film pattern 14 as the structured device layer 12.

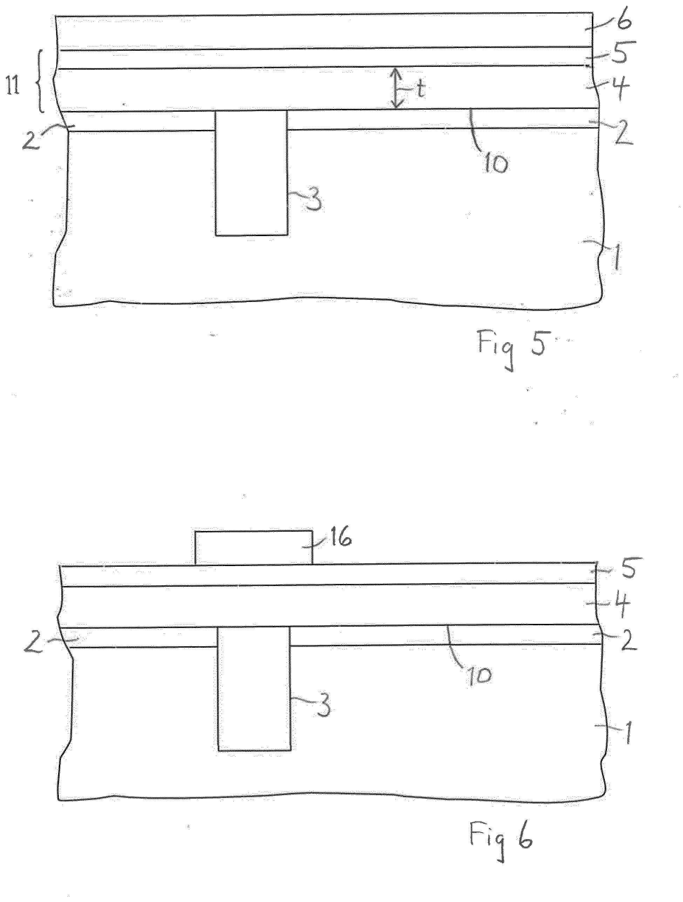

Figure 5 is a cross section according to Figure 1 for a further example of the method, in which a hardmask layer is applied as a further layer. Figure 5 shows a substrate 1 of semiconductor material carrying a device layer 2, which has an upper surface 10 and may be formed by a single layer or by a multiple layer. As in the preceding example, the device layer 2 can comprise any material used in semiconductor technology. A recess 3, which may especially be provided for a through substrate via, is formed extending from the surface 10 into the substrate 1.

In the variant of the method according to Figures 5 to 10, a dry film 4 is applied on the surface 10 of the device layer 2, and a hardmask layer 5 is applied on the dry film 4. The dry film 4 and the hardmask layer 5 are provided as a mask layer 11, which covers the recess 3 and renders a planar upper surface of the device. As in the preceding example, an organic material may be especially suitable for the dry film 4, which is preferably applied with a thickness t in the range from 5 µm to 50 µm. If the dry film 4 is formed from polyimide, it is stable in temperatures of up to 350°C.

The hardmask layer 5 may be Si, SiO₂, Si₃N₄, Al or another metal, for instance, and may be deposited at a temperature of typically less than 350°C to allow for thermal stability of the dry film 4. If a metal like Al is applied for the hardmask layer 5, sputtering or PVD (plasma-enhanced vapor deposition) at temperatures of less than 200°C is feasible and allows an application of a large variety of organic materials for the dry film 4.

A resist layer 6, which may comprise an organic resist, for instance, is applied on the hardmask layer 5. The resist layer 6 is preferably very thin, so that its thickness is much less than 1 µm, thus allowing for small structures to be resolved. A photolithography is performed, in which the resist layer 6 is subjected to a patterned light exposure and subsequent development, so that it can be partially removed according to the desired pattern by means of a solvent.

Figure 6 is a cross section according to Figure 5 after the patterning of the resist layer 6 into a resist mask 16.

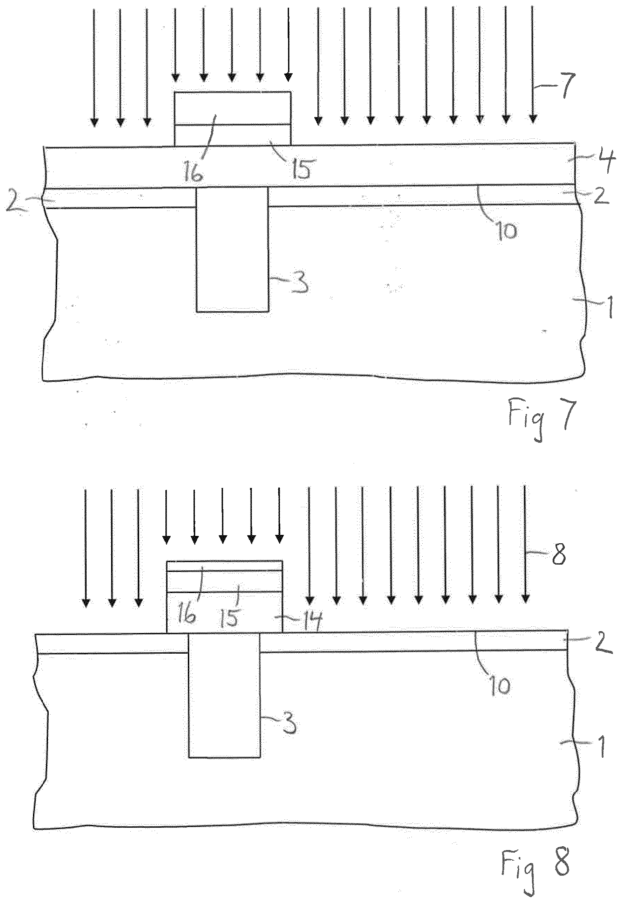

Figure 7 is a cross section according to Figure 6 after structuring the hardmask layer 5 into a hardmask 15. The resist mask 16 is used as an etch mask. The hardmask layer etching 7 is indicated in Figure 7 by a plurality of arrows pointing downwards. If the etching process, which may be reactive ion etching (RIE), is selective with respect to the material of the dry film 4, the etching stops on the dry film 4. The resist mask 16 is partially consumed during this etching step.

Figure 8 is a cross section according to Figure 7 after structuring the dry film 4 to form a dry film pattern 14. The hardmask 15 is used as an etch mask in this etching step, which may be reactive ion etching (RIE) using a chemistry based on CF₄, for example. The residual portion of the resist mask 16 may be left on the hardmask 15 during the dry film etching, or it may be removed by O₂, CF₄/O₂ or another suitable chemistry before the etching of the dry film 4 takes place. The dry film etching 8 is indicated in Figure 8 by a plurality of arrows pointing downwards. The etching stops on the surface 10 of the device layer 2. As the dry film 4 had been applied sufficiently thick, the dry film pattern 14 and the hardmask 15 still cover the recess 3. The hardmask 15 may be left on the dry film pattern 14 or be removed, for example by using a suitable wet or dry etch process that is selective with respect to the dry film pattern 14.

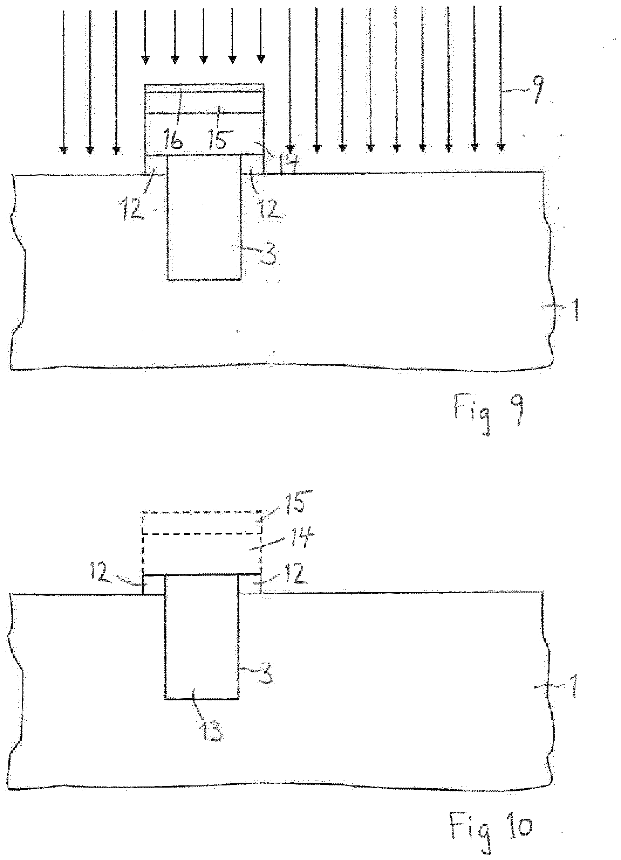

Figure 9 is a cross section according to Figure 8 after the structuring of the device layer 2. This is performed using the dry film pattern 14 as an etch mask. During the etching process the hardmask 15 may be left on the dry film pattern 14, as shown in Figure 9 as an example. Instead, the remaining portion of the resist mask 16 and the hardmask 15 may be removed before the device layer 2 is structured. The device layer etching 9 is indicated in Figure 9 by a plurality of arrows pointing downwards. Residual portions of the device layer 2 remain under the dry film pattern 14 as the structured device layer 12.

Figure 10 is a cross section according to Figure 9 after the etching of the device layer 2. The broken lines in Figure 10 indicate an optional removal of the hardmask 15 and the dry film pattern 14, which can be removed using O₂ or CF₄/O₂ or any other suitable chemistry, for example. The hardmask 15 and the dry film pattern 14 may instead be left as a cover of the recess 3 to close the inner volume 13.

The use of an additional hardmask layer 5 enables to pattern a dry film 4 that is much thicker than a dry film formed by a spin-on resist. As a dry film that is insensitive to light can be used in the described method, a much better film strength can be achieved, which enhances the properties of the dry film that are important for an effective sealing of the recess 3. In particular, the mechanical stability of the cover of the recess is improved. Furthermore, very small feature sizes can be realized by the described method, which also obviates the need to apply special CMOS-incompatible developers.

## Claims

1. A method of structuring a device layer of a recessed semiconductor device, comprising:
- providing a semiconductor substrate (1) with a device layer (2) having a surface (10),
- forming a recess (3) extending from the surface (10) into the substrate (1), wherein the recess (3) forms a via in the substrate (1), and
- structuring the device layer (2), wherein
- a dry film (4) is applied on the surface (10) of the device layer (2) after forming the recess (3) and before structuring the device layer (2), the dry film (4) covering the recess (3),
- a resist layer (6) is applied on or above the dry film (4) and is patterned into a resist mask (16),
- a dry film pattern (14) is formed from the dry film (4) according to the pattern of the resist mask (16), and
- the device layer (2) is structured using the dry film pattern (14) as an etch mask,
- the dry film pattern (14) is left covering an inner volume (13) of the recess (3) after structuring the device layer (2), and
- the dry film (4) is formed by dry-film lamination.

2. The method of claim 1, wherein the dry film (4) is formed from an organic material.

3. The method of claim 2, wherein the dry film (4) is formed from polyimide.

4. The method of one of claims 1 to 3, wherein the dry film (4) is applied with a thickness (t) in the range from 5 µm to 50 µm.

5. The method of one of claims 1 to 4, wherein the resist layer (6) is formed by spin-coating.

6. The method of one of claims 1 to 5, wherein the resist layer (6) is directly applied on the dry film (4), and the resist mask (16) is used to etch the dry film (4), thus forming the dry film pattern (14).

7. The method of one of claims 1 to 5, further comprising:
- a hardmask layer (5) being applied on the dry film (4),
- the resist layer (6) being applied on the hardmask layer (5),
- using the resist mask (16) to structure the hardmask layer (5) into a hardmask (15), and
- using the hardmask (15) to structure the dry film (4) into the dry film pattern (14).

8. The method of claim 7, wherein the resist mask (16) is removed before the dry film (4) is structured into the dry film pattern (14) using the hardmask (15).

9. The method of claim 8, wherein the hardmask (15) is removed before the device layer (2) is structured using the dry film pattern (14).

10. A semiconductor device, comprising:
- a semiconductor substrate (1) with a recess (3) forming a via opening, and
- a structured device layer (12), having a surface (10), wherein
- the recess (3) extends from the surface (10) into the substrate (1),
- the structured device layer (12) is arranged between the substrate (1) and a dry film pattern (14),
- the dry film pattern (14) comprises outlines that correspond to outlines of the structured device layer (12),
- the dry film pattern (14) covers the recess (3),
- the dry film pattern (14) is left covering an inner volume (13) of the recess (3) after structuring the device layer (2), and
- the dry film (4) is formed by dry-film lamination.

11. The semiconductor device of claim 10, wherein the dry film pattern (14) comprises an organic material.

12. The semiconductor device of claim 11, wherein the dry film pattern (14) comprises polyimide.

13. The semiconductor device of one of claims 10 to 12, wherein the dry film pattern (14) is arranged between the structured device layer (12) and a hardmask (15) comprising a material selected from the group consisting of silicon, SiO₂, Si₃N₄ and aluminum.

## Patentansprüche

1. Verfahren zum Strukturieren einer Bauteilschicht eines vertieften Halbleiterbauteils, umfassend:
- Bereitstellen eines Halbleitersubstrats (1) mit einer Bauteilschicht (2), die eine Oberfläche (10) hat,
- Ausbilden einer Vertiefung (3), die sich von der Oberfläche (10) aus in das Substrat (1) erstreckt, wobei die Vertiefung (3) eine Durchkontaktierung in dem Substrat (1) bildet, und
- Strukturieren der Bauteilschicht (2), wobei
- nach dem Ausbilden der Vertiefung (3) und vor dem Strukturieren der Bauteilschicht (2) ein Trockenfilm (4) auf die Oberfläche (10) der Bauteilschicht (2) aufgebracht wird, wobei der Trockenfilm (4) die Vertiefung (3) bedeckt,
- eine Resist-Schicht (6) auf oder über dem Trockenfilm (4) aufgebracht und zu einer Resist-Maske (16) gestaltet wird,
- ein Trockenfilmmuster (14) auf dem Trockenfilm (4) entsprechend dem Muster der Resist-Maske (16) ausgebildet wird, und
- die Bauteilschicht (2) unter Verwendung des Trockenfilmmusters (14) als Ätzmaske strukturiert wird,
- das Trockenfilmmuster (14) ein Innenvolumen (13) der Vertiefung (3) bedeckend nach dem Strukturieren der Bauteilschicht (2) belassen wird, und
- der Trockenfilm (4) durch Trockenfilmlaminierung ausgebildet ist.

2. Verfahren nach Anspruch 1, wobei der Trockenfilm (4) aus einem organischen Material ausgebildet wird.

3. Verfahren nach Anspruch 2, wobei der Trockenfilm (4) aus Polyimid ausgebildet wird.

4. Verfahren nach einem der Ansprüche 1 bis 3, wobei der Trockenfilm (4) mit einer Dicke (t) im Bereich von 5 µm bis 50 µm aufgebracht wird.

5. Verfahren nach einem der Ansprüche 1 bis 4, wobei die Resist-Schicht (6) durch Schleuderbeschichtung ausgebildet wird.

6. Verfahren nach einem der Ansprüche 1 bis 5, wobei die Resist-Schicht (6) direkt auf den Trockenfilm (4) aufgebracht wird, und die Resist-Maske (16) zum Ätzen des Trockenfilms (4) verwendet wird, wodurch das Trockenfilmmuster (14) ausgebildet wird.

7. Verfahren nach einem der Ansprüche 1 bis 5, darüber hinaus umfassend:
- eine Hartmaskenschicht (5), die auf den Trockenfilm (4) aufgebracht ist,
- eine Resist-Schicht (6), die auf die Hartmaskenschicht (5) aufgebracht ist,
- Verwenden der Resist-Maske (16), um die Hartmaskenschicht (5) zu einer Hartmaske (15) zu strukturieren, und
- Verwenden der Hartmaske (15), um den Trockenfilm (4) zu dem Trockenfilmmuster (14) zu strukturieren.

8. Verfahren nach Anspruch 7, wobei
die Resist-Maske (16) entfernt wird, bevor der Trockenfilm (4) unter Verwendung der Hartmaske (15) zu dem Trockenfilmmuster (14) strukturiert wird.

9. Verfahren nach Anspruch 8, wobei
die Hartmaske (15) entfernt wird, bevor die Bauteilschicht (2) unter Verwendung des Trockenfilmmusters (14) strukturiert wird.

10. Halbleiterbauteil, umfassend:
- ein Halbleitersubstrat (1) mit einer Vertiefung (3), die eine Durchkontaktierungsöffnung bildet,
- eine strukturierte Bauteilschicht (12), die eine Oberfläche (10) hat, wobei
- sich die Vertiefung (3) von der Oberfläche (10) aus in das Substrat (1) erstreckt,
- die strukturierte Bauteilschicht (12) zwischen dem Substrat (1) und einem Trockenfilmmuster (14) angeordnet ist,
- das Trockenfilmmuster (14) Konturen umfasst, die den Konturen der strukturierten Bauteilschicht (12) entsprechen,
- das Trockenfilmmuster (14) die Vertiefung (3) bedeckt,
- das Trockenfilmmuster (14) ein Innenvolumen (13) der Vertiefung (3) bedeckend nach dem Strukturieren der Bauteilschicht (2) belassen wird, und
- der Trockenfilm (4) durch Trockenfilmlaminierung ausgebildet ist.

11. Halbleiterbauteil nach Anspruch 10, wobei das Trockenfilmmuster (14) ein organisches Material umfasst.

12. Halbleiterbauteil nach Anspruch 11, wobei das Trockenfilmmuster (14) Polyimid umfasst.

13. Halbleiterbauteil nach einem der Ansprüche 10 bis 12,
wobei das Trockenfilmmuster (14) zwischen der strukturierten Bauteilschicht (12) und einer Hartmaske (15) angeordnet ist, die ein Material umfasst, das aus der Gruppe ausgewählt ist, die aus Silicium, SiO₂, Si₃N₄ und Aluminium besteht.

## Revendications

1. Procédé de structuration d'une couche de dispositif d'un dispositif semiconducteur en retrait, comprenant :
- la mise à disposition d'un substrat semiconducteur (1) doté d'une couche de dispositif (2) présentant une surface (10),
- la formation d'un retrait (3) s'étendant depuis la surface (10) dans le substrat (1), sachant que le retrait (3) forme une interconnexion dans le substrat (1), et
- la structuration de la couche de dispositif (2), sachant que
- un film sec (4) est appliqué sur la surface (10) de la couche de dispositif (2) après la formation du retrait (3) et avant la structuration de la couche de dispositif (2), le film sec (4) recouvrant le retrait (3),
- une couche de résist (6) est appliquée sur ou au-dessus du film sec (4) et est dotée d'un motif formant un masque de résist (16),
- un motif de film sec (14) est formé à partir du film sec (4) selon le motif du masque de résist (16), et
- la couche de dispositif (2) est structurée moyennant le motif de film sec (14) en tant que masque de gravure,
- le motif de film sec (14) est laissé recouvrir un volume intérieur (13) du retrait (3) après la structuration de la couche de dispositif (2), et
- le film sec (4) est formé par stratification du film sec.

2. Le procédé de la revendication 1, sachant que le film sec (4) est formé à partir d'un matériau organique.

3. Le procédé de la revendication 2, sachant que le film sec (4) est formé à partir de polyimide.

4. Le procédé de l'une des revendications 1 à 3, sachant que le film sec (4) est appliqué avec une épaisseur (t) comprise dans la plage de 5 µm à 50 µm.

5. Le procédé de l'une des revendications 1 à 4, sachant que la couche de résist (6) est formée par revêtement par centrifugation.

6. Le procédé de l'une des revendications 1 à 5, sachant que la couche de résist (6) est directement appliquée sur le film sec (4), et le masque de résist (16) est utilisé pour graver le film sec (4), formant ainsi le motif de film sec (14).

7. Le procédé de l'une des revendications 1 à 5, comprenant en outre :
- l'application d'une couche de masque dur (5) sur le film sec (4),
- l'application de la couche de résist (6) sur la couche de masque dur (5),
- l'utilisation du masque de résist (16) pour structurer la couche de masque dur (5) en un masque dur (15), et
- l'utilisation du masque dur (15) pour structurer le film sec (4) en le motif de film sec (14).

8. Le procédé de la revendication 7, sachant que
le masque de résist (16) est enlevé avant que le film sec (4) soit structuré en le motif de film sec (14) moyennant le masque dur (15).

9. Le procédé de la revendication 8, sachant que
le masque dur (15) est enlevé avant que la couche de dispositif (2) soit structurée moyennant le motif de film sec (14) .

10. Dispositif semiconducteur, comprenant :
- un substrat semiconducteur (1) doté d'un retrait (3) formant une ouverture d'interconnexion,
- une couche de dispositif (12) structurée, présentant une surface (10), sachant que
- le retrait (3) s'étend depuis la surface (10) dans le substrat (1),
- la couche de dispositif (12) structurée est agencée entre le substrat (1) et un motif de film sec (14),
- le motif de film sec (14) comprend des contours qui correspondent à des contours de la couche de dispositif (12) structurée,
- le motif de film sec (14) recouvre le retrait (3),
- le motif de film sec (14) est laissé recouvrir un volume intérieur (13) du retrait (3) après la structuration de la couche de dispositif (2), et
- le film sec (4) est formé par stratification de film sec.

11. Le dispositif semiconducteur de la revendication 10, sachant que le motif de film sec (14) comprend un matériau organique.

12. Le dispositif semiconducteur de la revendication 11, sachant que le motif de film sec (14) comprend du polyimide.

13. Le dispositif semiconducteur de l'une des revendications 10 à 12, sachant que le motif de film sec (14) est agencé entre la couche de dispositif (12) structurée et un masque dur (15) comprenant un matériau sélectionné dans le groupe constitué par le silicium, SiO₂, Si₃N₄ et l'aluminium.
